# EUROPÄISCHE PATENTSCHRIFT

(11) **EP 1 898 682 B1**
(45) Veröffentlichungstag und Bekanntmachung des Hinweises auf die Patenterteilung: **11.05.2011**
(21) Anmeldenummer: 07017347.1
(22) Anmeldetag: 05.09.2007
(51) Int. Cl.: H05K 3/38, H05K 3/18

(54) **Metallisierte Kunststoffoberfläche sowie Verfahren zum Bearbeiten und Metallisieren von Kunststoffoberflächen**
Metallised plastic surface and method for processing and metallising plastic surfaces
Surface en plastique métallisée et procédé de traitement et de métallisation de surfaces en matière synthétique

(30) Priorität: 05.09.2006 DE 102006041610
(43) Veröffentlichungstag der Anmeldung: 12.03.2008
(73) Patentinhaber: Harting AG, 2500 Biel 6 (CH)
(72) Erfinder: Stauffer, Bernhard, 3239 Dotzigen (CH); Gliss, Christine, 4500 Solothurn (CH); Grätz, Michael, 4500 Solothurn (CH); Krause, Jens, 92318 Neumarkt i.d. Oberpfalz (DE)
(74) Vertreter: Prinz & Partner

(56) Entgegenhaltungen:
- EP-A- 1 274 288
- EP-A- 1 383 360
- WO-A-2004/114734
- US-A- 5 192 015
- M. GIOUSUF, A. GRABEIN, U. SCHOLZ: "Untersuchungen zur Einsetzbarkeit der Ultraschall-Drahtbondtechnik zur Kontaktierung in miniaturisierten MID-Gehäusen für die Mikrosystemtechnik (Vorhaben AiF 12417 N)" Juli 2002 (2002-07), HAHN-SCHICKARD-GESELLSCHAFT; INSTITUT FÜR MIKROAUFBAUTECHNIK , BREITSCHEIDSTR. 2B 70174 STUTTGART, GERMANY , XP002527364 From Internet <URL: http://www.uni-stuttgart.de/hsg-imat/aif12 417.pdf> * Seite 4 * * Seite 39 * * Seite 64 - Seite 67 *
- HÜSKE M ET AL: "Laser supported activation and additive metallization of thermoplastics for 3D-MIDS" PROCEEDINGS OF THE 3RD LANE, XX, XX, 28. März 2001 (2001-03-28), Seiten 1-12, XP002242586

## Beschreibung

Die Erfindung bezieht sich auf ein Bauteil aus Kunststoff gemäß dem Oberbegriff des Anspruchs 1 sowie auf ein Verfahren zum Bearbeiten und Metallisieren von Kunststoffoberflächen.

Aufgrund der möglich gewordenen Miniaturisierung von Spritzgusskonturen und Leiterstrukturen auf MID (Moulded Interconnect Device) kommt die Nutzung von MID als Halbleitergehäuse immer mehr in Betracht. Insbesondere für Sensoren oder Multichipanordnungen auf engstem Raum oder unter speziellen geometrischen Bedingungen stellen MID eine Alternative zu gängigen Gehäusetechniken dar. Elektronische und mechanische Bauteile sogenannte Mikroelektromechanische Systeme (MEMS) werden mit der Hilfe dieser Technik miteinander verbunden und gestatten einen großen Gestaltungsbereich.

Schaltungsträger in Form von spritzgegossener Kunststoffverbindungsteile, sind eine konsequente Weiterentwicklung, in der die elektrischen und mechanischen Eigenschaften vereint werden, um eine hohe Integration zu erhalten. MID's sind zumeist dreidimensionale Formteile, die aus thermoplastischen Kunststoffen gespritzt werden. Anschließend wird auf der Oberfläche des Formteils die Struktur des Leiterbildes aufgebracht. Es gibt im wesentlichen zwei Verfahren. Das Zweikomponentenspritzgussverfahren (2K) und die Laser Direkt Strukturierung oder LDS-Verfahren.

Beim 2K-MID-Verfahren werden zwei verschiedene Kunststoffmassen zu einem Körper geformt. Davon ist die eine Masse in einem chemischen Abscheideprozess metallisierbar, während sich die andere Masse in diesem Prozess passiv verhält. Nach der Metallisierung ist eine selektive Beschichtung erreicht, die zum Beispiel die Form von Leiterzügen haben kann. Diese Leiterzüge befinden sich überall, wo die metallisierbare Masse die Körperoberfläche bildet. Isolationsfläche entstehen dementsprechend dort, wo die passive Masse die Oberfläche bildet.

Im Abschlussbericht der Hahn-Schickard-Gesellschaft "Untersuchungen zur Einsetzbarkeit der Ultraschall-Drahtbondtechnik zur Kontaktierung in miniaturisierten MID-Gehäusen für die Mikrosystemtechnik (Vorhaben AiF 12417N)" von M. Giousuf, A. Grabein, U. Scholz vom Juli 2002, Institut für Mikroaufbautechnik in Stuttgart, XP 002527364, wird auf die Problematik der Ultraschall-Drahtbondtechnik abhängig von der Oberflächenrauigkeit von Kontaktierflächen eingegangen.

EP 1 383 360 A1 offenbart einen spritzgegossenen Leiterträger und ein Verfahren zu seiner Herstellung, wobei ein Zwei-Komponenten-Spritzgießverfahren angewandt wird. Als Material für ein zweites Trägersubstrat wird ein nicht metallisierbares Kunststoffmaterial verwendet, das eine Laserstrahlaktivierung zulässt.

In dem Artikel "Laser Supported Activation and Additive Metallization of Thermoplastics for 3D-MIDS" von M. Hüske et al. (Proceedings of the 3rd Lane vom 28. März 2001, Seiten 1 bis 12, XP 002242586) wird das LDS-Verfahren vorgestellt und mit der indirekten Laseraktivierung und anderen Metallisierungsverfahren für Kunststoff verglichen.

Das LDS-Verfahren ist in der Patentanmeldung DE 101 32 092 A1 beschrieben. Die Grundlage für das LDS-Verfahren bilden dotierte Thermoplaste. Ein Laser aktiviert gezielt Bereiche, die anschließend in einem chemischen Bad metallisiert werden. Zur Kontaktierung der mit dem Laser aktivierten Bereiche gibt es verschiedene Techniken.

In der Patentanmeldung DE 102 56 719 A1 wird eine Kontaktierung mit Hilfe der Schneid-Klemm-Technik vorgeschlagen.

Darüber hinaus findet das Wire-Bond-Verfahren Verwendung. Hierbei erfolgt die Kontaktierung durch Reib- oder Thermoreibschweißen mittels Ultraschall.

Die Wire-Bond-Technologie ist die kosteneffektivste Lösung einer Kontaktierungstechnik. Sie ist daher auch die mit Abstand gebräuchlichste Technik. Die Drähte zur Kontaktierung bestehen aus Gold, Aluminium oder Kupfer. Die Durchmesser liegen im Bereich von 15 - 50 µm bis hin zu einigen 100 µm bei Hochstrom-Anwendungen.

Zum Herstellen der Kontaktierung der Halbleiterbauelemente oder Leitungsschichten beim Wire-Bonding kommen hauptsächlich zwei Verfahren zum Einsatz: Das Wedge-Bonding Verfahren und das Ball-Bonding Verfahren.

Beim Wedge-Bonding Verfahren wird das Ende des Bonddrahtes mit Hilfe einer Nadel auf die zu kontaktierende Fläche gepresst und mit einem kurzen Ultraschallpuls verschweißt.

Das Ball-Bonding oder auch Thermokompressionsverfahren Verfahren läuft analog mit dem Unterschied, dass der Bonddraht mit Hilfe eines Lichtbogens aufgeschmolzen wird und sich am Ende ein Kügelchen bildet, welches dann mit Hilfe eines Ultraschallpulses mit der kontaktierenden Fläche verschweißt wird. Darüber hinaus wird bei diesem Verfahren eine Kapillare statt einer Nadel verwendet, so dass der Draht senkrecht auf die Kontaktfläche geführt wird und nicht seitlich wie beim Wedge-Bonding.

Das Ball-Bonding ist begrenzt auf Gold- und Kupferdraht, da üblicherweise Wärmeenergie benötigt wird. Beim Wedge-Bonding wird entweder Gold- oder Aluminiumdraht benutzt, wobei die Zufuhr von Wärmeenergie nur bei Golddraht notwendig ist. In jedem Fall wird eine Verbindung des Drahtes mit einer Kontaktfläche mit einer Kombination von Druck, Wärmeenergie und Ultraschallenergie hergestellt, die eine Verschmelzung der Komponenten bewirkt.

Die Qualität oder die Haltbarkeit des Bondprozesses wird durch verschiedene äußere Parameter bestimmt. Diese setzen sich zusammen aus den Parametern, die sich aus dem Verfahren ergeben. Dazu gehören Anpressdruck des Bonddrahtes an die Kontaktfläche, Temperatur, Zeit und Ultraschall-Leistung. Weiterhin hängt die Qualität des Bondprozesses von den verwendeten Werkstoffen den Verformungs-, Diffusionseigenschaften und deren festkörperphysikalischen Reaktionen zwischen den verschiedenen Schichtsystemen ab.

Bei der Laserstrukturierung von Schaltungsträgern in Form von spritzgegossenen Kunststoffverbindungsteilen MID kommt es durch Laserbehandlung, d.h. Energieeintrag in den Kunststoff, zur Aufrauhung der Oberfläche. Die Aufrauhung der Oberfläche führt zwar zu einer besseren Haftung der nachträglich aufgebrachten metallisierten Schicht, gleichzeitig aber auch zur Ausbildung von Hohlräumen und Poren, die eine dauerhafte Kontaktierung der Kontaktflächen erschweren. Es kommt zu einer hohen Zahl von Fehlbondungen und entsprechenden Ausschußkosten.

Der Erfindung liegt daher die Aufgabe zugrunde, ein prozesssicheres Kontaktieren von Al- oder Au-Drähten mit einem Durchmesser von 20, 33 oder 50 µm an einem aus elektrischen leitfähigem Material bestehenden Kontaktbereich zu gewährleisten.

Zur Lösung dieser Aufgabe ist erfindungsgemäß bei einem Bauteil der eingangs genannten Art vorgesehen, dass das Kunststoffmaterial unterhalb des Kontaktbereichs komprimiert ist, so dass im Kontaktbereich Poren und/oder Hohlräume der aufgerauten Oberflächen verringert und/oder beseitigt sind.

Gemäß einer bevorzugten Ausführungsform der Erfindung ist vorgesehen, dass die metallisierte Kunststoffoberfläche aus 4 - 10 µm Cu, 5 - 9 µm Ni und 0,05 - 0,2 µm Au besteht und eine elektrische Leiterbahnstruktur aufweist, wobei der Kontaktbereich zum Anschluß von Al- oder Au-Bonddrähten, mit Durchmesser von 18-50 µm, vorgesehen ist.

Die Aufgabe der Erfindung wird auch gelöst durch ein Verfahren zum Metallisieren von Kunststoffbauteilen mit den Merkmalen des Anspruchs 6, wobei die zu metallisierende Oberfläche des Bauteils einschließlich der Kontaktbereiche vor dem Metallisieren durch Laserbestrahlung aufgerauht wird, anschließend an vorgesehenen Kontaktbereichen ein Kompressionsschritt durchgeführt wird, in welchem die Oberfläche zumindest abschnittsweise komprimiert wird, so daß Poren und/oder Hohlräume der aufgerauhten Oberfläche verringert und/oder beseitigt werden, und daß anschließend die aufgerauhte Oberfläche metallisiert wird.

Vorzugsweise ist vorgesehen, daß der Kompressionsschritt mittels eines Stempels ausgeführt wird, der vorzugsweise vor dem Aufpressen auf die Kunststoffoberfläche erwärmt wurde.

Vorteilhafte Ausgestaltungen der Erfindung ergeben sich aus den Unteransprüchen.

Der mit dieser Erfindung erzielte Vorteil besteht darin, daß die Anzahl der Fehlbondungen und somit die Ausschusskosten erheblich vermindert werden, wenn sich unterhalb des zu kontaktierenden Bereiches keine Hohlräume oder Poren im Kunststoff befinden. Dadurch wird erreicht, dass die Kontaktfläche unter Druck- oder Ziehkräften sowie die durch den Ultraschall erzeugten Vibrationen nicht verformt oder in Schwingung versetzt wird. Desweiteren wird eine reproduzierbare Einbringung der zum Bonden benötigten Ultraschallenergie ermöglicht. Dies ist eine wesentliche Voraussetzung für einen prozesssicheren Bondvorgang.

Ein Ausführungsbeispiel der Erfindung ist in der Zeichnung dargestellt und wird im folgenden näher erläutert. Es zeigen:
- Fig. 1 ein Schnittbild einer metallisierten Kunststoffoberfläche ohne Kompression;
- Fig. 2 ein Schnittbild einer metallisierten Kunststoffoberfläche mit Glättung durch eine kontrollierte Beschichtung;
- Fig. 3 ein Schnittbild einer metallisierten Kunststoffoberfläche durch eine kontrollierte Beschichtung und nach der Kompression.

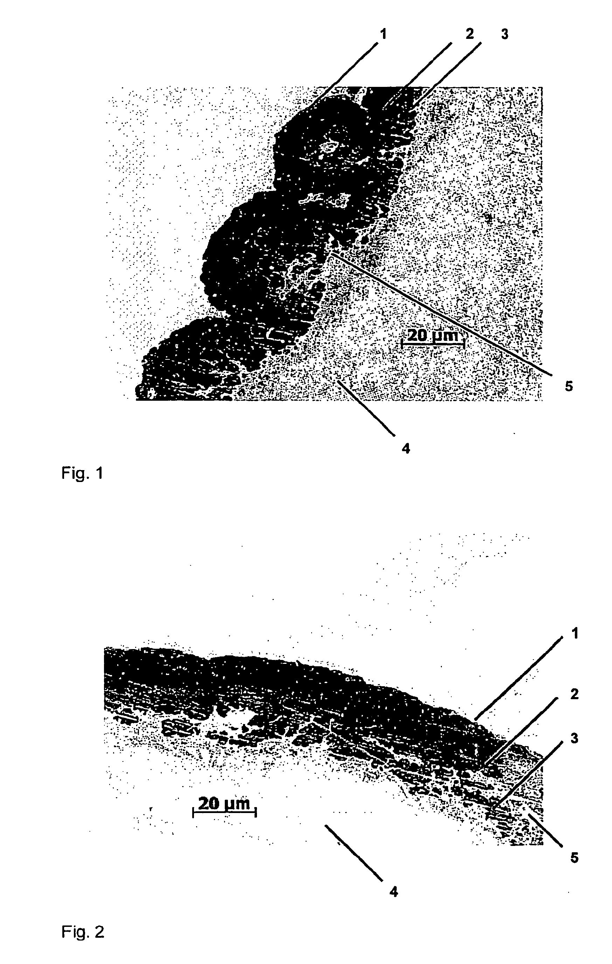

In der Fig. 1 ist ein Schnitt durch eine metallisierte Kunststoffoberfläche gezeigt. Die Schichten bestehen aus einer Goldschicht 1, einer Nickelschicht 2 und einer Kupferschicht 3. Deutlich ist eine ungleichmäßige Schichtstruktur mit einer starken Ausbildung von Poren 5 zu erkennen. Die Goldschicht ist aufgrund der verhältnismäßigen Dicke von ca. 0.1 µm nicht von der Nickelschicht zu unterscheiden und daher nicht auf dem Bild zu erkennen.

Die Fig. 2 zeigt einen Schnitt durch eine metallisierte Kunststoffoberfläche durch eine kontrollierte Beschichtung. Die immer noch vorhandene starke Ausbildung von Poren 5 verhindert einen sicheren Bondvorgang.

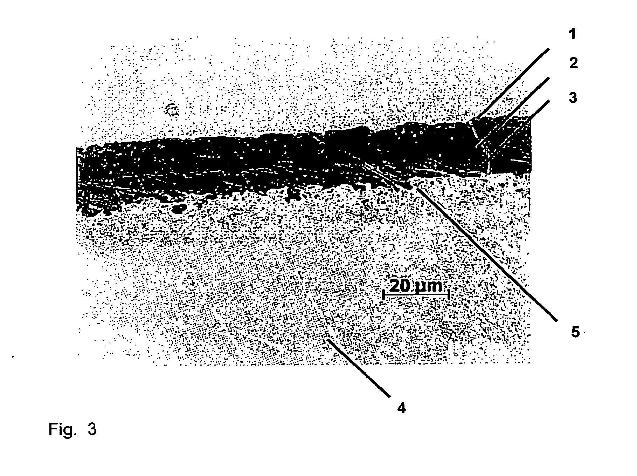

Die Fig. 3 zeigt die erfindungsgemäße komprimierte Kunststoffoberfläche. Die Porenfreiheit unterhalb der Metallisierung gewährleistet ein prozesssicheren Bondvorgang.

## Patentansprüche

1. Bauteil aus Kunststoff, das eine metallisierte Oberfläche aufweist, wobei die Beschichtung (1, 2, 3) insbesondere aus Kupfer, Nickel und/oder Gold besteht und wobei abschnittsweise mindestens ein Kontaktbereich vorgesehen ist, der zum Anschließen von Bonddrähten dient, wobei die mit der Beschichtung versehene Oberfläche des Kunststoffbauteils durch Laserbestrahlung aufgeraut ist und dadurch gebildete Hohlräume und Poren (5) aufweist, **dadurch gekennzeichnet, dass** das Kunststoffmaterial unterhalb des Kontaktbereichs komprimiert ist, so dass im Kontaktbereich Poren und/oder Hohlräume der aufgerauten Oberfläche verringert und/oder beseitigt sind.

2. Bauteil nach Anspruch 1, **dadurch gekennzeichnet, dass** die metallisierte Oberfläche aus 4 - 10 µm Cu, 5 - 9 µm Ni und 0,05 - 0,2 µm Au besteht und eine elektrische Leiterbahnstruktur aufweist, wobei der Kontaktbereich zum Anschluss von Al- oder Au-Bonddrähten, mit Durchmesser von 18-50 µm, vorgesehen ist.

3. Bauteil nach Anspruch 2, **dadurch gekennzeichnet, dass** der Kontaktbereich für die Kontaktierung eines Bonddrahtes mit dem Kontaktbereich mittels Reib- oder Thermoreibschweißen vorgesehen ist.

4. Bauteil nach einen der vorhergehenden Ansprüche, **dadurch gekennzeichnet, dass** die zu kontaktierenden Bauteile Halbleiterelemente oder Mikroelektromechanische (MEMS) Systeme sind.

5. Bauteil nach einen der vorhergehenden Ansprüche **dadurch gekennzeichnet, dass** die metallisierte Kunststoffoberfläche eine ebene Leiterplatte oder ein zwei- oder dreidimensionaler spritzgegossener Schaltungsträger (MID) ist.

6. Verfahren zum Bearbeiten und Metallisieren von Kontaktbereichen für den Anschluss von Bonddrähten auf Kunststoffteilen, wobei die zu metallisierende Oberfläche des Bauteils einschließlich der Kontaktbereiche vor dem Metallisieren durch Laserbestrahlung aufgeraut wird, anschließend an vorgesehenen Kontaktbereichen ein Kompressionsschritt durchgeführt wird, in welchem die Oberfläche zumindest abschnittsweise komprimiert wird, so dass Poren (5) und/oder Hohlräume der aufgerauten Oberfläche verringert und/oder beseitigt werden, und dass anschließend die aufgeraute Oberfläche metallisiert wird.

7. Verfahren nach Anspruch 6, **dadurch gekennzeichnet, dass** der Kompressionsschritt mittels eines Stempels ausgeführt wird, der vorzugsweise vor dem Aufpressen auf die Kunststoffoberfläche erwärmt wurde.

8. Verfahren nach Anspruch 6 oder Anspruch 7, **dadurch gekennzeichnet, dass** die Kontaktierung eines Bonddrahtes mit einem Kontaktbereich mittels Reib- oder Thermoreibschweißen erfolgt.

## Claims

1. A component of plastic which has a metallized surface, the coating (1, 2, 3) consisting in particular of copper, nickel and/or gold, and at least one contact region being provided in sections which serves for connecting bonding wires, the surface, provided with the coating, of the plastic component being roughened by laser irradiation and having cavities and pores (5) formed thereby, **characterized in that** the plastic material below the contact region is compressed, so that in the contact region, pores and/or cavities of the roughened surface are reduced and/or eliminated.

2. The component according to claim 1, **characterized in that** the metallized surface consists of 4 - 10 µm Cu, 5 - 9 µm Ni and 0.05 - 0.2 µm Au and has an electrical conductor path structure, the contact region being provided for connecting Al or Au bonding wires having a diameter of from 18-50 µm.

3. The component according to claim 2, **characterized in that** the contact region is provided for contacting a bonding wire with the contact region by means of friction welding or thermal friction welding.

4. The component according to any of the preceding claims, **characterized in that** the components to be contacted are semiconductor elements or microelectromechanical systems (MEMS).

5. The component according to any of the preceding claims, **characterized in that** the metallized plastic surface is a flat circuit board or a two- or three-dimensional molded interconnect device (MID).

6. A method of treating and metallizing contact regions for the connection of boding wires on plastic parts, the surface, to be metallized, of the component inclusive of the contact regions being roughened by laser irradiation prior to the metallization, followed by a compression step performed on provided contact regions in which the surface is compressed at least in sections, so that pores (5) and or cavities of the roughened surface are reduced and/or eliminated, and that subsequently the roughened surface is metallized.

7. The method according to claim 6, **characterized in that** the compression step is carried out by means of a stamp which has preferably been heated before being pressed onto the plastic surface.

8. The method according to claim 6 or 7, **characterized in that** the contacting of a bonding wire with a contact region is effected by means of friction welding or thermal friction welding.

## Revendications

1. Composant en matière plastique qui présente une surface métallisée, le revêtement (1, 2, 3) étant en particulier en cuivre, en nickel et/ou en or, et par tronçons étant au moins prévue une zone de contact qui sert au branchement de fils de liaison, la surface du composant en matière plastique, pourvue du revêtement, étant rendue rugueuse par irradiation au laser et présentant des cavités et pores (5) ainsi formés, **caractérisé en ce que** la matière plastique est comprimée en-dessous de la zone de contact, de telle sorte que dans la zone de contact les pores et/ou cavités de la surface rendue rugueuse sont réduit(e)s et/ou éliminé(e)s.

2. Composant selon la revendication 1, **caractérisé en ce que** la surface métallisée est constituée par 4 - 10 µm de Cu, 9 µm de Ni et 0,05 - 0,2 µm de Au et présente une structure de piste conductrice, la zone de contact pour le branchement de fils de liaison en Al ou Au est prévue avec un diamètre de 18-50 µm.

3. Composant selon la revendication 2, **caractérisé en ce que** la zone de contact pour la mise en contact d'un fil de liaison avec la zone de contact, est prévu au moyen de soudage par friction ou de soudage par friction thermique.

4. Composant selon l'une quelconque des revendications précédentes, **caractérisé en ce que** les composants à mettre en contact sont des éléments de semi-conducteurs ou des systèmes microélectromécaniques (MEMS).

5. Composant selon l'une quelconque des revendications précédentes, **caractérisé en ce que** la surface de matière plastique métallisée est une carte de circuits imprimés plane ou un support de circuit (MID) bidimensionnel ou tridimensionnel moulé par injection.

6. Procédé de traitement et de métallisation de zones de contact pour le branchement de fils de liaison sur des pièces en matière plastique, la surface du composant à métalliser y compris les zones de contact étant rendues rugueuses par irradiation au laser avant la métallisation, sur les zones de contact prévues étant ensuite effectuée une étape de compression dans laquelle la surface est comprimée au moins par tronçons, de telle sorte que des pores (5) et/ou cavités de la surface rendue rugueuse sont réduit(e)s et/ou éliminé(e)s, et en ce qu'ensuite, la surface rendue rugueuse est métallisée.

7. Procédé selon la revendication 6, **caractérisé en ce que** l'étape de compression est réalisée au moyen d'un poinçon qui est de préférence chauffé avant l'estampage sur la surface de matière plastique.

8. Procédé selon la revendication 6 ou la revendication 7, **caractérisé en ce que** la mise en contact d'un fil de liaison avec une zone de contact a lieu au moyen de soudure par friction ou de soudure par friction thermique.
